# EUROPÄISCHE PATENTSCHRIFT

(11) **EP 1 861 877 B1**
(45) Veröffentlichungstag und Bekanntmachung des Hinweises auf die Patenterteilung: **28.10.2009**
(21) Anmeldenummer: 06707478.1
(22) Anmeldetag: 08.03.2006
(51) Int. Cl.: H01L 23/473

(54) **Vorrichtung zur Kühlung von elektronischen Bauteilen**
Device for cooling electronic components
Dispositif de refroidissement de composants électroniques

(30) Priorität: 16.03.2005 DE 102005012501
(43) Veröffentlichungstag der Anmeldung: 05.12.2007
(73) Patentinhaber: Behr Industry GmbH & Co. KG, 70469 Stuttgart (DE)
(72) Erfinder: KLENK, Andreas, 71640 Ludwigsburg (DE); SIEBRECHT, Thomas, 71642 Ludwigsburg (DE)
(74) Vertreter: Grauel, Andreas
(86) Internationale Anmeldenummer: PCT/EP2006/002126
(87) Internationale Veröffentlichungsnummer: WO 2006/097228

(56) Entgegenhaltungen:
- DE-A1- 10 207 873
- DE-A1- 19 511 991
- US-A- 5 514 906

## Beschreibung

Die Erfindung betrifft eine Vorrichtung zur Kühlung von elektronischen Bauelementen nach dem Oberbegriff des Patentanspruches 1 - bekannt durch die DE 41 31 739 A1 der Anmelderin.

Kühlvorrichtungen für elektronische Bauelemente sind in verschiedenen Bauarten bekannt, wobei die Kühlung entweder durch Umgebungsluft oder durch ein flüssiges Kühlmittel erfolgt. Durch die EP 0 278 240 A2 wurde ein Kühlkörper mit einer wärmeleitenden, metallischen Grundplatte bekannt, auf welcher ein Kühlelement in Form eines Rippenpaketes durch Lötung befestigt ist, welches durch einen Luftstrom gekühlt wird. Die wärmeleitende Grundplatte befindet sich dabei in wärmeleitendem Kontakt mit den elektronischen Bauelementen. Durch die DE 198 06 978 A1 wurde eine Vorrichtung zur Kühlung elektronischer Bauelemente durch Konvektion bekannt, wobei ein Kühlluftstrom durch mit Rippen bestückte Kanäle eines Kühlkörpers zur Wärmeabfuhr geleitet wird. Der Kühlkörper ist wärmeleitend mit den elektronischen Bauteilen verbunden.

Durch die DE 41 31 739 A1 der Anmelderin wurde eine Kühleinrichtung für elektrische Bauelemente bekannt, wobei zwei plattenförmige Bauelemente, eine wärmeleitende Grundplatte und eine Deckplatte, miteinander verbunden sind und einen Hohlraum einschließen, welcher von einem flüssigen Kühlmittel durchströmt wird. Zur Erhöhung des Wärmeüberganges ist in dem Hohlraum eine Einlage zur Turbulenzerzeugung angeordnet und vorzugsweise mit der Grundplatte verlötet. Damit wird eine wirksame Wärmeabfuhr der durch die elektrischen Bauelemente erzeugten Verlustleistung erreicht. Durch die DE 199 11 205 A1 oder die DE-A-10207873 wurde eine ähnliche flüssigkeitsgekühlte Vorrichtung für elektronische Bauelemente bekannt, wobei eine Grundplatte aus einem metallischen Werkstoff und eine Deckplatte aus einem Kunststoff hergestellt sind und zwischen sich einen Hohlraum mit einer Kühlrippe einschließen, welcher von dem flüssigen Kühlmittel durchströmt wird. In einer bevorzugten Ausführungsform sind die Kühlmittelanschlüsse auf derselben Seite angeordnet, so dass eine Umlenkung des Kühlmittels im Hohlraum bewirkt wird. Nachteilig bei den bekannten Kühlvorrichtungen, insbesondere den flüssigkeitsgekühlten Vorrichtungen ist der Herstellungsaufwand für die Einzelteile wie Grundplatte und Deckplatte sowie deren Montage und Abdichtung.

Es ist Aufgabe der vorliegenden Erfindung, eine Vorrichtung zur Kühlung von elektronischen Bauelementen der eingangs genannten Art konstruktiv zu vereinfachen und die Herstellkosten der Vorrichtung zu reduzieren.

Diese Aufgabe wird durch die Merkmale des Patentanspruches 1 gelöst. Erfindungsgemäß ist vorgesehen, dass der vom Kühlmittel durchströmbare Hohlraum durch so genannte Stapelscheiben gebildet wird, d. h. wannenförmig ausgebildete, durch Tiefziehen herstellbare Blechteile mit einem umlaufenden, hoch stehenden Rand. Die Stapelscheiben werden ineinander gesetzt bzw. ineinander gestapelt und schließen zwischen sich eine so genannte Turbulenzeinlage ein, d. h. ein Element, welches den Wärmeübergang zwischen dem Kühlmittel und den Stapelscheiben erhöht. Stapelscheiben sind an sich aus verschiedenen Anwendungen bekannt, z. B. durch die EP 0 623 798 A2 als Kühlmittel/Ölkühler. Die Stapelscheiben, d. h. wannenförmig ausgebildete Wärmetauscherplatten mit umlaufenden Rändern sind als Gleichteile ausgebildet und zu einem Stapel aufgeschichtet, wobei sich zwischen den Stapelscheiben Turbulenzbleche befinden. Der Stapelscheibenölkühler wird von zwei Medien, nämlich Öl und Kühlmittel durchströmt. Ähnliche Anwendungen für Stapelscheiben-Wärmeübertrager sind aus der DE 197 11 258 A1 sowie der DE 195 11 991 A1 bekannt, wobei auch gasförmige Medien am Wärmetausch beteiligt sind. Der Vorteil der erfindungsgemäßen Kühlvorrichtung liegt in dem einfachen Aufbau und den daraus resultierenden geringen Herstellkosten. Die Stapelscheiben sind durch spanlose Umformung (Stanzen, Tiefziehen, Prägen) aus einem Blech, vorzugsweise aus einer Aluminiumlegierung kostengünstig herstellbar. Die Verbindung beider Scheiben zu einem Hohlkörper bzw. Kühlelement erfolgt durch Verlötung, wobei einerseits die umlaufenden Ränder miteinander und andererseits die Turbulenzeinlage mit den Stapelscheiben verlötet werden. Im Unterschied zu den herkömmlichen Stapelscheiben-Wärmeübertragern ist die erfindungsgemäße Kühlvorrichtung ein Einkreiskühler, d. h. es ist nur ein Strömungsmedium an der Wärmeübertragung beteiligt - die abzuführende Verlustwärme wird durch Wärmeleitung in die Stapelscheiben eingeleitet.

Zwei Stapelscheiben, eine untere Stapelscheibe und eine obere Stapelscheibe mit eingeschlossener Turbulenzeinlage bilden einen Strömungskanal, wobei nach einer vorteilhaften Weiterbildung der Erfindung auch mehrere derartige Strömungskanäle übereinander angeordnet und vorzugsweise parallel vom Kühlmittel durchströmbar sind. Bei zwei Strömungskanälen sind also drei Stapelscheiben, eine untere, eine mittlere und eine obere Stapelscheibe ineinander gesetzt und bilden den Hohlraum. Der zusätzliche Strömungskanal hat den Vorteil, dass ein höherer Kühlmitteldurchsatz bei geringerem Druckabfall möglich und eine verbesserte Kühlung erreichbar ist.

Nach einer vorteilhaften Weiterbildung der Erfindung ist die untere Stapelscheibe wärmeleitend, vorzugsweise durch Verlötung mit einer Grundplatte verbunden, die ihrerseits wärmeleitend mit den Elektronikbauelementen verbunden ist. Damit ergibt sich eine gute wärmeleitende Verbindung, so dass die in den Bauelementen entstehende Verlustwärme unmittelbar an das strömende Kühlmittel abgeleitet werden kann.

In weiterer vorteilhafter Ausgestaltung der Erfindung ist die obere Stapelscheibe durch eine Deckplatte verstärkt, die ihrerseits mit der Stapelscheibe verlötet ist. Vorteilhafterweise sind in der oberen Stapelscheibe bzw. Deckplatte Öffnungen für den Zu- und Abfluss des Kühlmittels bzw. entsprechende Kühlmittelanschlussstutzen vorgesehen. Alle Teile der erfindungsgemäßen Kühlvorrichtung sind vorzugsweise aus Aluminiumwerkstoffen bzw. Aluminiumlegierungen hergestellt und können in einem Arbeitsgang hartgelötet werden. Damit entfallen auch aufwendige Montagearbeiten für das Fügen und Abdichten einer herkömmlichen Grund- und Deckplatte. Darüber hinaus wird durch die Verlötung eine hervorragende Wärmeleitung erzielt.

Die Form, d. h. der Grundriss der erfindungsgemäßen Kühlvorrichtung ist an sich beliebig, z. B. quadratisch, kreisförmig, oval oder länglich - eine bevorzugte Ausführungsform sieht einen etwa rechteckförmigen Grundriss mit abgerundeten Ecken vor.

Ein Ausführungsbeispiel der Erfindung ist in der Zeichnung dargestellt und wird im Folgenden näher beschrieben. Es zeigen
- Fig. 1: eine erfindungsgemäße Kühlvorrichtung für elektronische Bauelemente in perspektivischer Darstellung,
- Fig. 2: die Kühlvorrichtung gemäß Fig. 1 in einer Ansicht,
- Fig. 3: die Kühlvorrichtung gemäß Fig. 1 in einer Seitenansicht,
- Fig. 4: die Kühlvorrichtung gemäß Fig. 1 in einer Draufsicht und
- Fig. 5: die Kühlvorrichtung gemäß Fig. 1 in einer Schnittdarstellung.

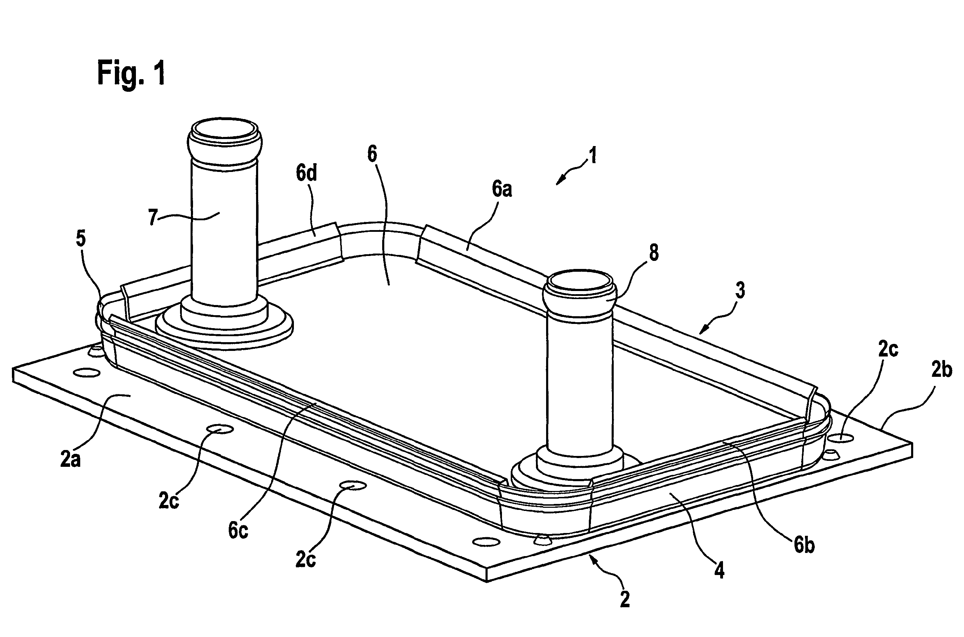

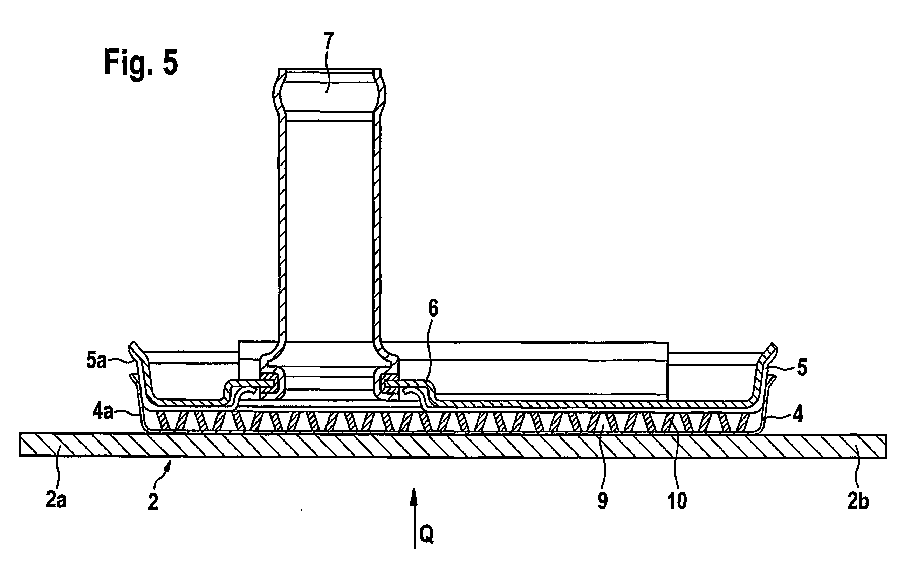

**Fig. 1** zeigt eine Kühlvorrichtung 1 zur Kühlung von nicht dargestellten elektronischen Bauelementen, z. B. Halbleitern, welche bei ihrem Betrieb eine erhebliche Verlustwärme erzeugen. Die Kühlvorrichtung 1 besteht aus einer Grundplatte 2, auf welcher ein Einkreis-Stapelscheibenkühler 3 stoffschlüssig, vorzugsweise durch Löten befestigt ist. Die Grundplatte 2 ist auf beiden Seiten plan ausgebildet und weist zwei Randleisten 2a, 2b auf, in welchen Befestigungsbohrungen 2c angeordnet sind. Die Kühlvorrichtung 1 wird mittels der Grundplatte 2 an den nicht dargestellten elektronischen Bauelementen vollflächig und mittels einer gut wärmeleitenden Verbindung befestigt, so dass ein Wärmeeintrag in die gesamte Fläche der Grundplatte 2 erfolgen kann. Der Stapelscheibenkühler 3 besteht - soweit aus Fig. 1 ersichtlich - aus einer unteren, mit der Grundplatte 2 stoffschlüssig verbundenen Stapelscheibe 4, einer oberen, in die untere Stapelscheibe 4 eingesetzten Stapelscheibe 5, einer Deckplatte 6 sowie einem Kühlmitteleintrittsstutzen 7 und einem Kühlmittelaustrittsstutzen 8. Die Decklatte 6 weist - ähnlich wie die beiden Stapelscheiben 4, 5 - einen umlaufenden Rand auf, welcher in den Eckbereichen ausgeklinkt ist, so dass vier Randstreifen 6a, 6b, 6c, 6d stehen bleiben. Der Begriff "Stapelscheibe" entspricht dem eingangs zitierten Stand der Technik und wird unten - zu Fig. 5 - genauer erläutert.

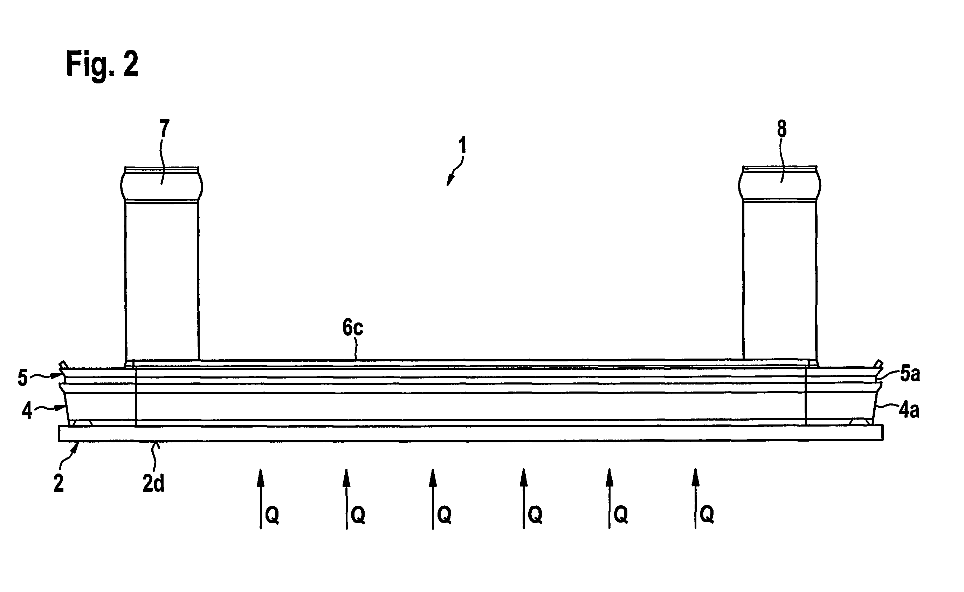

**Fig. 2** zeigt die Kühlvorrichtung 1 in einer Ansicht, wobei für gleiche Teile die gleichen Bezugzahlen verwendet werden. Die Grundplatte 2 weist eine bene und glatte Unterseite 2d auf, über welche der Wärmeeintrag, dargestellt durch Pfeile Q, erfolgt. Die Stapelscheiben 4, 5 weisen einen umlaufenden, hochgestellten, leicht konisch verlaufenden Rand 4a, 5a auf. Der Rand 5a der oberen Stapelscheibe 5 wird von dem Randstreifen 6c der hier nicht sichtbaren Deckplatte 6 übergriffen.

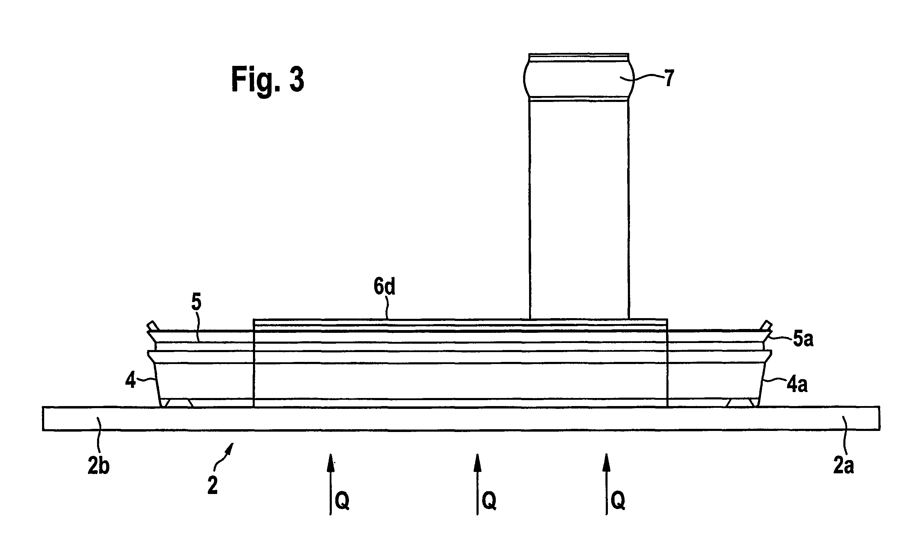

**Fig. 3** zeigt eine Seitenansicht der Kühlvorrichtung 1, leicht vergrößert. Die Grundplatte 2 überragt die Stapelscheiben 5, 6 nach beiden Seiten mit den Randleisten 2a, 2b. Die Ränder 4a, 5a weisen die selbe Kontur wie in Fig. 2 auf, wobei der obere Rand 5a von dem Randstreifen 6d der hier nicht sichtbaren Deckplatte 6 übergriffen wird.

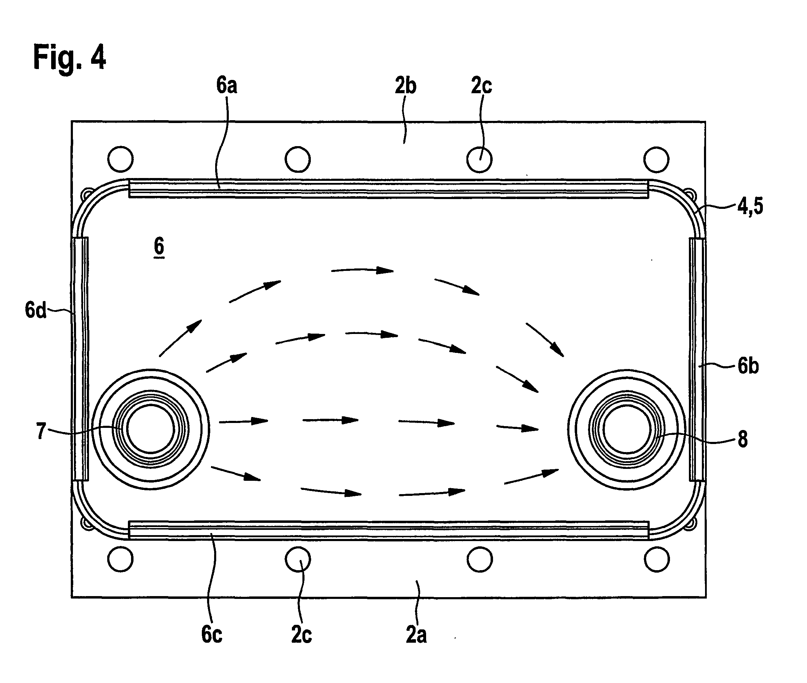

**Fig. 4** zeigt die Kühlvorrichtung 1 in einer Draufsicht - dabei ist der rechteckige Grundriss der Stapelscheiben 4, 5 mit abgerundeten Eckbereichen sichtbar. Die Befestigungsbohrungen 2c in den Randleisten 2a, 2b sind außerhalb der Stapelscheiben 4, 5 angeordnet und somit frei zugänglich. Die Pfeile zwischen den Kühlmittelstutzen 7, 8 deuten den Strömungsverlauf des Kühlmittels an.

**Fig. 5** zeigt einen Schnitt durch die Kühlvorrichtung 1 im Bereich eines Kühlmittelanschlussstutzens, hier des Eintrittsstutzens 7, welcher in die Deckplatte 6 und die obere Stapelscheibe 5 dicht eingelötet ist. Zwischen der unteren Stapelscheibe 4 und der oberen Stapelscheibe 5 ist ein Hohlraum 9 bzw. ein Strömungskanal 9 gebildet, in welchem ein Turbulenzblech 10 angeordnet und beiderseits mit den Stapelscheiben 4, 5 verlötet ist. Die Stapelscheiben 4, 5 sind in ihren umlaufenden, sich überlappenden Randbereichen 4a, 5a miteinander verlötet. Die Ausbildung der Stapelscheiben ist im Übrigen aus dem eingangs genannten Stand der Technik bekannt, d. h. die Stapelscheiben werden durch spanlose Umformung wie Stanzen, Prägen und Tiefziehen aus einem relativ dünnen Blech, vorzugsweise Aluminiumblech hergestellt und erfordern relativ einfache Werkzeuge, wie sie auch bei den bekannten Zweikreis-Stapelscheiben-Wärmeübertragern verwendet werden. Ebenso ist das Turbulenzblech 10 ein aus dem Stand der Technik bekanntes Bauteil. Es dient nicht nur der Verbesserung der Wärmeübertragung zwischen Kühlmittel und den angrenzenden Wänden der Stapelscheiben 4, 5, sondern wirkt infolge der Verlötung auch als Zuganker und erhöht somit die Innendruckfestigkeit des Strömungskanals 9. Auf der Außenseite der oberen Stapelscheibe 5 liegt die etwas dickere Deckplatte 6 auf, die somit eine Verstärkung der Stapelscheibe 5 bewirkt und auch den Stutzen 7, 8 den notwendigen Halt gibt.

Die Funktion der Kühlvorrichtung 1 ist die Folgende: Wärme wird entsprechend den Pfeilen Q von nicht dargestellten elektronischen Bauelementen durch Wärmeleitung in die Grundplatte 2 eingetragen und durch Wärmeleitung und Wärmeübergang an das durch den Hohlraum 9 strömende Kühlmittel übertragen. Vorzugweise wird als Kühlmittel, welches über den Kühlmittelstutzen 7 eintritt und über den Kühlmittelstutzen 8 wieder austritt, ein Wasser-Glykol-Gemisch verwendet.

Sämtliche Teile der Kühlvorrichtung 1 sind aus Aluminium bzw. Aluminiumlegierungen hergesellt und werden in einem Arbeitsgang in einem nicht dargestellten Lötofen hartgelötet, wodurch einerseits die erforderliche feste Verbindung zwischen den Bauteilen und andererseits die notwendige Dichtheit erzielt wird.

Im dargestellten Ausführungsbeispiel ist nur ein Strömungskanal 9, der identisch mit dem Hohlraum 9 ist, vorgesehen. Möglich ist jedoch auch und im Rahmen der Erfindung liegend, dass mindestens ein weiterer Strömungskanal vorgesehen wird, indem eine weitere Stapelscheibe und ein weiteres Turbulenzblech in die obere Stapelscheibe 5 eingesetzt werden. Beide Strömungskanäle können dann vorzugsweise parallel zueinander vom Kühlmittel Kühlmittel durchströmt werden, wobei eine Wärmeleitung vom unteren in den oberen Strömungskanal, d. h. vom stärker erwärmten Kühlmittel zum weniger stark erwärmten Kühlmittel erfolgt. Gleichzeitig wird durch die Vergrößerung des Strömungsquerschnittes ein geringerer kühlmittelseitiger Druckabfall erreicht. Eine Steigerung der Wärmeabfuhr durch eine Erhöhung der Zahl der Strömungskanäle bzw. Stapelscheiben ist jedoch nur mit wenigen Strömungskanälen möglich.

## Patentansprüche

1. Vorrichtung zur Kühlung von elektronischen Bauelementen, im Wesentlichen bestehend aus plattenförmigen Bauteilen, welche einen von einem flüssigen Kühlmittel durchströmbaren, eine Einlage (10) zur Turbulenzerzeugung aufweisenden Hohlraum (9) bilden, wobei die plattenförmigen Bauteile als ineinander stapelbare, wannenförmig ausgebildete, einen umlaufenden Rand (4a, 5a) aufweisende, spanlos umformbare Blechteile, ausgebildet sind, **dadurch gekennzeichnet, dass** die plattenförmigen Bauteile (4, 5) als Gleichteile ausgebildet sind.

2. Vorrichtung nach Anspruch 1, **dadurch gekennzeichnet, dass** der Hohlraum (9) durch mindestens einen jeweils von zwei plattenförmigen Bauteilen (4, 5) begrenzten Strömungskanal (9) gebildet wird.

3. Vorrichtung nach Anspruch 1 oder 2, **dadurch gekennzeichnet, dass** das untere plattenförmige Bauteil (4) mit einer Grundplatte (2), insbesondere einer metallischen Grundplatte stoffschlüssig verbunden, insbesondere verlötet ist.

4. Vorrichtung nach Anspruch 1, 2 oder 3, **dadurch gekennzeichnet, dass** das obere plattenförmige Bauteil (5) mittels einer Deckplatte (6) verstärkt ist.

5. Vorrichtung nach einem der Ansprüche 1 bis 4, **dadurch gekennzeichnet, dass** die Einlage (10) mit den plattenförmigen Bauteilen (4, 5) stoffschlüssig verbunden, insbesondere verlötet ist.

6. Vorrichtung nach einem der Ansprüche 1 bis 5, **dadurch gekennzeichnet, dass** die plattenförmigen Bauteile (4, 5) randseitig, d. h. im Bereich der umlaufenden Ränder (4a, 5a) stoffschlüssig miteinander verbunden, insbesondere verlötet sind.

7. Vorrichtung nach einem der Ansprüche 1 bis 6, **dadurch gekennzeichnet, dass** in dem oberen plattenförmigen Bauteil (5), respektive der Deckplatte (6) mindestens eine Zufluss- und mindestens eine Abflussöffnung (7, 8) für das Kühlmittel angeordnet sind.

8. Vorrichtung nach Anspruch 7, **dadurch gekennzeichnet, dass** im Bereich der Zu- und Abflussöffnungen Anschlussstutzen (7, 8) angeordnet und mit dem oberen plattenförmigen Bauteil (5), respektive der Deckplatte (6) stoffschlüssig verbunden, insbesondere verlötet sind.

9. Vorrichtung nach einem der Ansprüche 2 bis 8, **dadurch gekennzeichnet, dass** die Grundplatte (2) als Befestigungsplatte (2a, 2b) mit Befestigungsmitteln, insbesondere Befestigungsbohrungen (2c) ausgebildet ist.

10. Vorrichtung nach einem der Ansprüche 1 bis 9, **dadurch gekennzeichnet, dass** die plattenförmigen Bauteile (4, 5) einen etwa rechteckförmigen Grundriss aufweisen.

11. Vorrichtung nach einem der Ansprüche 1 bis 10, **dadurch gekennzeichnet, dass** die einzelnen Bauteile (2, 4, 5, 6, 7, 8, 10) aus Aluminiumwerkstoffen herstellbar und durch Hartlöten in einem Arbeitsgang miteinander verbunden sind.

## Claims

1. Device for cooling electronic component elements, essentially consisting of plate-shaped components which form a cavity (9) which can be crossflown by a by a fluid coolant, forming an insert (10) for producing turbulence, wherein the plate-shaped components are formed as interstacked, trough-shaped sheet metal parts which can be shaped in a non-cutting manner having a peripheral edge (4a, 5a), **characterised in that** the plate-shaped components (4, 5) are formed as common parts.

2. Device according to claim 1, **characterised in that** the cavity (9) is formed by at least one flow channel (9) defined respectively by two plate-shaped components (4, 5).

3. Device according to claim 1 or 2, **characterised in that** the lower plate-shaped component (4) is positively connected to a base plate (2), especially a metallic base plate, especially soldered.

4. Device according to claim 1, 2 or 3, **characterised in that** the upper plate-shaped component (5) is reinforced by a cover plate (6).

5. Device according to one of claims 1 to 4, **characterised in that** the insert (10) is positively connected to the plate-shaped components (4, 5), especially soldered.

6. Device according to one of claims 1 to 5, **characterised in that** the plate-shaped components (4, 5) are positively connected to one another in the edge region, that is, in the region of the peripheral edges (4a, 5a), especially soldered.

7. Device according to one of claims 1 to 6, **characterised in that** at least one inlet and at least one outlet opening (7, 8) for the coolant are arranged in the upper plate-shaped component respective to the cover plate (6).

8. Device according to claim 7, **characterised in that** fittings (7, 8) are arranged in the region of the inlet and outlet openings, and are positively connected to the upper plate-shaped component (5) respective to the cover plate (6), especially soldered.

9. Device according to one of claims 2 to 8, **characterised in that** the base plate (2) is formed as securing plate (2a, 2b) with securing means, especially securing bores (2c).

10. Device according to one of claims 1 to 9, **characterised in that** the plate-shaped components (4, 5) have an approximately rectangular layout.

11. Device according to one of claims 1 to 10, **characterised in that** the individual components (2, 4, 5, 6, 7, 8, 10) can be produced of aluminium materials and are connected to one another in one operation by brazing.

## Revendications

1. Dispositif de refroidissement de composants électroniques se composant essentiellement de composants en forme de plaques qui forment un espace creux (9) pouvant être traversé par un agent de refroidissement liquide et présentant une pièce intercalaire (10) servant à la production de turbulences, où les composants en forme de plaques sont configurés, en forme de cuvette, comme des éléments en tôle empilables les uns dans les autres, usinables sans enlèvement de matière et comportant un bord circulaire (4a, 5a),
**caractérisé en ce que** les composants (4, 5) en forme de plaques sont configurés comme des pièces identiques.

2. Dispositif selon la revendication 1, **caractérisé en ce que** l'espace creux (9) est formé par au moins un conduit d'écoulement (9) limité à chaque fois par deux composants (4, 5) en forme de plaques.

3. Dispositif selon la revendication 1 ou 2, **caractérisé en ce que** le composant (4) du dessous, en forme de plaque, est assemblé par liaison de matière, en particulier brasé à une plaque de base (2), en particulier à une plaque de base métallique.

4. Dispositif selon la revendication 1, 2 ou 3, **caractérisé en ce que** le composant (5) du dessus, en forme de plaque, est renforcé par une plaque de recouvrement (6).

5. Dispositif selon l'une quelconque des revendications 1 à 4, **caractérisé en ce que** la pièce intercalaire (10) est assemblée par liaison de matière, en particulier brasée aux composants (4, 5) en forme de plaques.

6. Dispositif selon l'une quelconque des revendications 1 à 5, **caractérisé en ce que** les composants (4, 5) en forme de plaques sont assemblés par liaison de matière, en particulier brasés les uns aux autres, sur le bord, c'est-à-dire dans la zone des bords circulaires (4a, 5a).

7. Dispositif selon l'une quelconque des revendications 1 à 6, **caractérisé en ce qu'**au moins une ouverture d'alimentation et au moins une ouverture de sortie (7, 8), prévues pour l'agent de refroidissement, sont disposées dans le composant (5) du dessus, en forme de plaque, respectivement dans la plaque de recouvrement (6).

8. Dispositif selon la revendication 7, **caractérisé en ce que** des tubulures de raccordement (7, 8) sont disposées dans la zone des ouvertures d'alimentation et de sortie et assemblées par liaison de matière, en particulier brasées au composant (5) du dessus, en forme de plaque, respectivement à la plaque de recouvrement (6).

9. Dispositif selon l'une quelconque des revendications 2 à 8, **caractérisé en ce que** la plaque de base (2) est configurée comme une plaque de fixation (2a, 2b) comportant des moyens de fixation, en particulier des perçages de fixation (2c).

10. Dispositif selon l'une quelconque des revendications 1 à 9, **caractérisé en ce que** les composants (4, 5) en forme de plaques présentent une vue en plan de forme à peu près rectangulaire.

11. Dispositif selon l'une quelconque des revendications 1 à 10, **caractérisé en ce que** les différents composants (2, 4, 5, 6, 7, 8, 10) peuvent être réalisés dans des matériaux à base d'aluminium et sont assemblés les uns aux autres, par brasage fort, en une opération d'usinage.
